# EUROPEAN PATENT APPLICATION

(11) **EP 4 358 686 A1**
(43) Date of publication of application: **24.04.2024**
(21) Application number: 22202011.7
(22) Date of filing: 17.10.2022
(51) Int. Cl.: H10N 69/00, H10N 60/01, H03F 19/00

(54) **JOSEPHSON TRAVELLING WAVE PARAMETRIC AMPLIFIER AND MANUFACTURING METHOD THEREOF**

(71) Applicant: QuantWare Holding B.V., 2628 CJ Delft (NL)
(72) Inventor: Wesselink, Wouter Julian, 2628 CJ DELFT (NL); Bruno, Alessandro, 2628 CJ DELFT (NL); Waardenburg, Daan Maarten Alexander, 2628 CJ DELFT (NL); Basili, Stefanos, 2628 CJ DELFT (NL); Dobrovolskiy, Sergiy Mykolayovych, 2628 CJ DELFT (NL)
(74) Representative: Hoyng Rokh Monegier B.V.

(57) **Abstract**

Disclosed is a method of manufacturing a Josephson travelling wave parametric amplifier, JTWPA (400), which comprises providing, on a substrate (406), a bottom conductive layer (404, 405), a dielectric layer (408), and a top conductive layer (403), the top conductive layer at least partly forming nonlinear inductors (409), top capacitor plates of parallel plate capacitors and/or conductive strips interrupted by nonlinear inductors, wherein the top conductive layer (403) is formed using a single instance of an angled evaporation method. The nonlinear inductors (409) may comprise one or more Josephson junctions, and the bottom conductive layer (404, 405) may form a CPW transmission line structure (402).

## Description

### TECHNICAL FIELD

The present disclosure is generally directed to amplifiers and more particularly to traveling wave parametric amplifiers, and methods of using and fabricating traveling wave parametric amplifiers.

### BACKGROUND

Quantum computing systems often require one (or more) parametric amplifiers for amplifying signals from, and (feedback) control signals to, qubits in a Quantum Processing Unit (QPU).

Josephson travelling wave parametric amplifiers (JTWPA's) are microwave amplifiers that offer near quantum-limited broadband amplification of weak signals. This makes them a desirable component in for example the read-out chains of superconducting qubit systems.

JTWPA's consist of a superconducting transmission line interrupted by Josephson junctions or other nonlinear inductive elements such as superconducting quantum interference devices (SQUID's) or superconducting nonlinear asymmetric inductive elements (SNAIL's) or combinations thereof.

Amplification is achieved by a mixing process mediated by the nonlinearity of the nonlinear inductors. This mixing process allows for power transfer from a strong pump tone to a weak signal which is amplified. In the process, a tone called the idler is also generated.

Typically, capacitors are added periodically to the transmission line to achieve a certain characteristic impedance. In some implementations, resonant structures are added periodically to the transmission line to match the wavevectors of the pump tone to that of the signal and the idler in order to achieve efficient amplification.

Ideally, a JTWPA amplifies an input signal with a high gain exhibiting small ripples over a wide bandwidth. Given the large demand for JTWPA's, it is important that the JTWPA can be fabricated quickly and reliably. Due to the limited space available in qubit systems and the desire for integration of the amplifiers with other components, it is important that the JTWPA has a small footprint.

Different kinds of JTWPA's have been disclosed in earlier patent applications. WO 2021/214383 discloses a JTWPA that makes use of co-planar distributed resonant structures to achieve a phase match. Due to the small dielectric constant of vacuum, which acts as the effective dielectric for the distributed capacitance in these resonant structures, the phase velocity of microwaves in these resonant structures is high and the required length to achieve the desired resonance frequency is large. This means that the JTWPA occupies a large footprint. Other co-planar JTWPA designs may use interdigitated capacitors as part of their impedance or phase matching structures, but these suffer from the same limitation.

The JTWPA disclosed in WO 2022/120171 uses parallel plate capacitors with a high dielectric constant material separating the two capacitor plates. This allows for smaller impedance matching and phase matching structures. The fabrication of a JTWPA implementing parallel plate capacitors necessitates the fabrication of a conductive layer, followed by a dielectric layer followed by another conductive layer. The use of parallel plate capacitors leads to two new challenges.

Firstly, nonlinear inductors, which are typically and preferably fabricated using an angled evaporation method, cannot, up to now, be fabricated in the same step as either conductive layer. This is due to the shadows that arise from the angled evaporation, which can give rise to open circuits when a section of a layer fabricated using an angled evaporation method traverses a boundary of an underlying layer.

The necessity for separate fabrication steps to produce the bottom conductive layer, top conductive layer and the nonlinear inductors, in other words: the fact that the nonlinear inductors cannot be fabricated in the same step as either of the conductive layers, significantly complicates the fabrication process. This increases the chance of errors and lowers the fabrication throughput.

Secondly, the capacitance of parallel plate capacitors depends on the area of overlap between the top and bottom plate making the capacitance sensitive to alignment uncertainties of nanofabrication techniques.

It is worth stressing the origin of the need for angled evaporation methods in JTWPA production. Josephson junctions, which are the fundamental component of most nonlinear inductors, are typically and preferably fabricated by depositing a layer of superconducting material, on which an oxide layer is formed, followed by a second superconducting layer.

The critical current of the Josephson junction, a central property that determines the Josephson junction's nonlinear inductance, depends on the area of overlap between the two superconducting electrodes. Angled evaporation methods allow the precise targeting of the critical current. Angled evaporation methods comprise etching a pattern in a resist, thus exposing an underlying area, and evaporating material onto the resist and the exposed areas in such a way that certain regions of the exposed area are shadowed by the resist from the material deposited from one angle but not from the other. Only the area that is reached by material deposited from both directions forms the effective Josephson junction.

Three important factors that limit JTWPA's from being ideal are: (i) fabrication spreads in JTWPA components such as the capacitors leading to errors in the phase or impedance matching in the JTWPA which results in a lower gain and larger gain ripples, (ii) fabrication throughput and yield are limited by the number of fabrication steps and the complexity thereof, and (iii) the footprint of JTWPA's is typically limited by the capacitors comprising the impedance and phase matching structures, which are typically the largest elements in each unit cell.

Parallel plate capacitors are the most promising way of reducing the footprint of the JTWPA given their large capacitance per unit area, but they increase the number of fabrication steps and the sensitivity to layer misalignments. This leads to an increased risk of impedance and phase mismatches and the consequences thereof.

### SUMMARY

To address the above discussed drawbacks of the prior art, the present inventors realized that all three important challenges can be solved by integrating parallel plate capacitors in a JTWPA design in such a way that the number of fabrication steps and parameter spreads stay small. It is accordingly proposed, according to a first aspect of the disclosure, there is disclosed a method of manufacturing a Josephson travelling wave parametric amplifier (JTWPA). The method comprises: providing a substrate; providing, on the substrate, a bottom conductive layer; providing, on top of the substrate and the bottom conductive layer, a dielectric layer; and providing, by means of an angled evaporation method, a top conductive layer on top of said substrate, bottom conductive layer and dielectric layer. The top conductive layer can at least partly form one or more nonlinear inductors. The top conductive layer can at least partly form one or more top capacitor plates of one or more parallel plate capacitors and/or wherein the top conductive layer at least partly forms a top conductive strip interrupted by one or more nonlinear inductors. The top conductive layer can be formed using a single instance of the angled evaporation method.

In an embodiment of the first aspect, boundaries of the bottom conductive layer, wherever it is traversed by a section of the top conductive layer, can be placed at an angle other than zero from the projections of the directions of the angled evaporation of the top conductive layer in the plane of the substrate.

In an embodiment of the first aspect, a section of the bottom conductive layer which is traversed by a section of the top conductive layer can be formed in such a way that at least one of the vector components of the directions of angled evaporation that are parallel to the substrate is at an acute angle (< 90 degrees), preferably 45 degrees, to the normal vector of the boundary of the traversed section in the plane of the substrate.

In an embodiment of the first aspect, a section of the bottom conductive layer which is traversed by a section of the top conductive layer can have a boundary that is formed along a first direction parallel to the substrate; wherein a section of the dielectric layer which will be traversed by the section of the top conductive layer can have a boundary that is formed along a second direction parallel to the substrate; wherein the section of the top conductive layer can be formed along the second direction. The first direction and second direction can be non-parallel and non-perpendicular.

In an embodiment of the first aspect, the bottom conductive layer forms a part of a transmission line of the JTWPA which is interrupted by one or more nonlinear inductors. The transmission line has a co-planar waveguide geometry. The bottom conductive layer, the dielectric layer and the top conductive layer together form part of one or more parallel plate capacitors. The angled evaporation method at least partly forms the one or more top capacitor plates of one or more parallel plate capacitors and the one or more nonlinear inductors using the single instance of the angled evaporation method. Preferably, the angled evaporation method comprises multiple evaporation orientations. More preferably the angled evaporation method comprises two evaporation orientations.

In an embodiment of the first aspect, the top conductive layer can traverse the bottom conductive layer, and the top conductive layer can be connected galvanically to side conductive layers provided on the substrate and formed at a distance on either side of the bottom conductive layer such as to form a dielectric bridge. Preferably, the side conductive material can comprise superconducting material.

In an embodiment of the first aspect, the JTWPA can comprise a transmission line having a microstrip geometry such that the bottom conductive layer acts as a ground and such that the top conductive layer comprises one or more nonlinear inductors and a top conductive strip. The top conductive strip is interrupted by the one or more nonlinear inductors. The angled evaporation method forms at least partly the top conductive strip and the one or more nonlinear inductors using the single instance of the angled evaporation method. Preferably, the angled evaporation method comprises multiple evaporation orientations. More preferably, the angled evaporation method comprises two evaporation orientations.

In an embodiment of the first aspect, the bottom conductive layer and/or the top conductive layer can comprise superconducting material.

In an embodiment of the first aspect, the JTWPA further can comprise one or more parallel plate capacitors, comprising a bottom capacitor plate and a top capacitor plate. Either or both of the bottom and top capacitor plates can form part of either or both of the bottom and top conductive layers.

According to a second aspect of the disclosure, there is disclosed a Josephson travelling wave parametric amplifier (JTWPA) comprising: a substrate; a bottom conductive layer provided on top of the substrate; a dielectric layer provided on top of the substrate and the bottom conductive layer; and a top conductive layer provided by means of an angled evaporation method on top of the substrate, bottom conductive layer and dielectric layer. The top conductive layer can at least partly form one or more nonlinear inductors. The top conductive layer can at least partly form one or more top capacitor plates of one or more parallel plate capacitors and/or wherein the top conductive layer can at least partly form a top conductive strip interrupted by one or more nonlinear inductors. The top conductive layer can be formed using a single instance of the angled evaporation method.

In an embodiment of the second aspect, boundaries of the bottom conductive layer, wherever it is traversed by a section of the top conductive layer, can be at an angle other than zero from the projections of the directions of the angled evaporation of the top conductive layer in the plane of the substrate.

In an embodiment of the second aspect, a section of the bottom conductive layer which is traversed by a section of the top conductive layer can be formed in such a way that at least one of the vector components of the directions of angled evaporation that are parallel to the substrate can be at an acute angle (< 90 degrees), preferably 45 degrees, to the normal vector of the boundary of the traversed section in the plane of the substrate.

In an embodiment of the second aspect, a section of the bottom conductive layer which is traversed by a section of the top conductive layer can have a boundary that is formed along a first direction parallel to the substrate. A section of the dielectric layer which is traversed by the section of the top conductive layer can have a boundary that is formed along a second direction parallel to the substrate. The section of the top conductive layer can be formed along the second direction. The first direction and second direction can be non-parallel and non-perpendicular.

In an embodiment of the second aspect, the bottom conductive layer can form a part of a transmission line of the JTWPA which is interrupted by one or more nonlinear inductors. The transmission line can have a co-planar waveguide geometry. The bottom conductive layer, the dielectric layer and the top conductive layer together can form part of one or more parallel plate capacitors. The angled evaporation method can at least partly form the one or more top capacitor plates of one or more parallel plate capacitors and the one or more nonlinear inductors using the single instance of the angled evaporation method. Preferably, the angled evaporation method comprises multiple evaporation orientations. More preferably, the angled evaporation method comprises two evaporation orientations.

In an embodiment of the second aspect, the top conductive layer can traverse the bottom conductive layer. The top conductive layer can be connected galvanically to side conductive layers provided on the substrate and formed at a distance on either side of the bottom conductive layer such as to form a dielectric bridge. Preferably, the side conductive material comprises superconducting material.

In an embodiment of the second aspect, the JTWPA can comprise a transmission line having a microstrip geometry such that the bottom conductive layer acts as a ground and such that the top conductive layer comprises one or more nonlinear inductors and a top conductive strip. The top conductive strip can be interrupted by the one or more nonlinear inductors. The angled evaporation method can form at least partly the top conductive strip and the one or more nonlinear inductors using the single instance of the angled evaporation method. Preferably, the angled evaporation method comprises multiple evaporation orientations. More preferably, the angled evaporation method comprises two evaporation orientations.

In an embodiment of the second aspect, the bottom conductive layer and/or the top conductive layer can comprise superconducting material.

In an embodiment of the second aspect, the JTWPA further can comprise one or more parallel plate capacitors, comprising a bottom capacitor plate and a top capacitor plate. Either or both of the bottom and top capacitor plates can form part of either or both of the bottom and top conductive layers.

According to a third aspect of the disclosure, there is disclosed a parallel-plate capacitor, comprising: a bottom plate and a top plate, both made of conductive material and separated by a dielectric material, wherein the bottom plate and the top plate are made to overlap in such a way that the overlapping area defines a capacitance value for the parallel-plate capacitor. The bottom plate and the top plate can both be designed to extend on either side of the overlapping area by a predefined distance. The predefined distance can be chosen in such a way that the predefined distance is larger than the largest expected misalignment during manufacturing of the bottom plate and the top plate. Preferably, the area of overlap of the two plates forms a rectangle, a parallelogram or a cross-like pattern.

### BRIEF DESCRIPTION OF DRAWINGS

Embodiments will now be described, by way of example only, with reference to the accompanying schematic drawings in which corresponding reference symbols indicate corresponding parts, and in which:
FIG. 1A is a schematic diagram showing aspects of a number of unit cells of an example co-planar waveguide (CPW) JTWPA;
FIG. 1B is a schematic diagram showing a cross-sectional view of an example CPW transmission line and parallel plate capacitor;
FIG. 1C is a top view of the example CPW transmission line and parallel plate capacitor shown in FIG. 1B;
FIG. 2A is a schematic diagram showing aspects of a number of unit cells of an example microstrip (MS) JTWPA;
FIG. 2B is a schematic diagram showing a cross-sectional view of an example MS transmission line;
FIG. 2C is a top view of the example MS transmission line shown in FIG. 2B;
FIG. 3A is a schematic diagram showing, for the example of a CPW transmission line and parallel plate capacitor, how open circuits arise in a top conductive layer fabricated using an angled evaporation method;
FIG. 3B is a top view of the example CPW transmission line and parallel plate capacitor shown in FIG. 3A;
FIG. 4A is a schematic diagram showing aspects of a number of unit cells of an example JTWPA;
FIG. 4B is a schematic diagram showing, for the example of a CPW transmission line and parallel plate capacitor, how aspects of the present disclosure prevent the formation of open circuits in a top conductive layer fabricated using an angled evaporation method;
FIG. 4C is a top view of the example CPW transmission line and parallel plate capacitor shown in FIG. 4B;
FIG. 5 is a schematic diagram showing aspects of an example parallel plate capacitor.

### DESCRIPTION OF EMBODIMENTS

Hereinafter, certain embodiments will be described in further detail. It should be appreciated, however, that these embodiments may not be construed as limiting the scope of protection for the present disclosure.

As mentioned before, a JTWPA is a microwave parametric amplifier that amplifies a weak signal in transmission mode through a wave mixing process. In other words, the JTWPA comprises two ports of which one port is configured to receive one or more pump tones and one or more weak signal tones. A wave mixing process amplifies the one or more weak signal tones while they are transmitted through the JTPWA. The other port is configured to output the amplified one or more signal tones as well as possibly tones at other frequencies. It may comprise a transmission line which acts as a medium through which the various tones can propagate, and which is interrupted by nonlinear inductors and may further comprise parallel plate capacitors (among other components) that may comprise sections of a bottom conductive layer, a dielectric layer, and a top conductive layer. The transmission line, parallel plate capacitors and nonlinear inductors might be configured in such a way that signals transmitted through the JTWPA observe a certain predefined characteristic impedance.

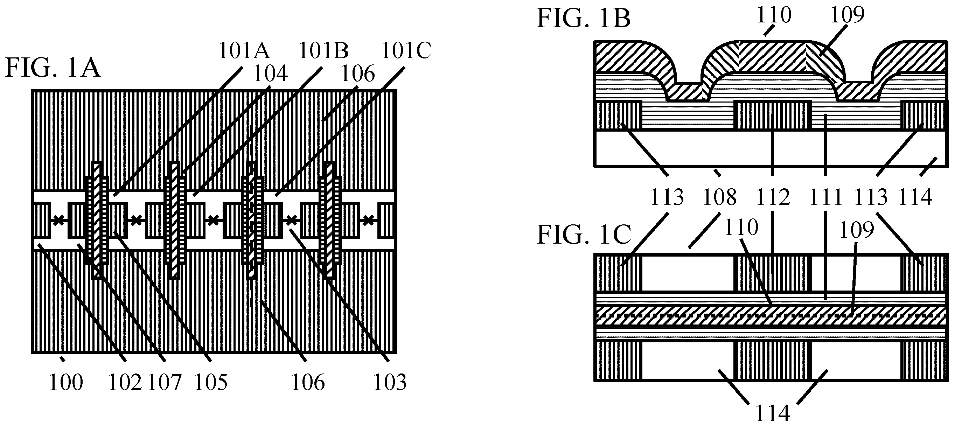

FIG. 1A is a schematic diagram showing aspects of a number of unit cells 101A-C of an example JTWPA 100.

JTWPA 100 includes a series of unit cells 101A-C, each comprising a transmission line 102, a nonlinear inductor 103, and a parallel plate capacitor 104. The unit cells 101A-C form the building blocks of the JTWPA 100 and are configured in such a way that a certain predefined characteristic impedance, dispersion relation and nonlinearity are met. In general, these parameters are typically chosen to optimise the performance of the JTWPA. A typical JTWPA contains hundreds to thousands of unit cells.

The transmission line 102 in the exemplary JTWPA 100 has a co-planar waveguide (CPW) geometry comprising of a central conductive strip 105 which is flanked on either side by a region of the exposed substrate 107, wherein the regions of the exposed substrate 107 are themselves flanked by a section of the conductive layer forming ground planes 106 which act as the ground, and which are realised on top of the substrate 107. The central conductive strip 105 is interrupted by the nonlinear inductors 103.

In some implementations, each nonlinear inductor 103 in the exemplary JTWPA 100 includes one or more Josephson junctions configured in parallel, in series, or in a combination thereof. In some implementations, the nonlinear inductors may be realised using an array of one or more Josephson junctions comprising two superconducting plates separated by an insulating layer. In other implementations, the nonlinear inductors may be realised using an array of one or more quantum interference devices (SQUID's) or superconducting nonlinear asymmetric inductive elements (SNAIL's) or any other parallel and/or series arrangement of one or more Josephson junctions or combination thereof.

In some implementations, some or each unit cell in the example JTWPA 100 may include resonant phase matching structures comprising a parallel plate capacitor shunted by an inductor, both of which are coupled capacitively to the central conductive strip. For clarity, FIG. 1A does not show such resonant phase-matching structures. Other phase matching structures, such as distributed resonant structures or a periodically varying design of the nonlinear inductors, may also be implemented.

In some implementations, some or all of the central conductive strip, the nonlinear inductors, the ground planes and the top capacitor plates may be made out of or comprise a superconducting material such as, but not limited to, aluminium and alloys containing niobium. The parallel plate capacitors may further be made out of dielectric materials such as but not limited to amorphous silicon, amorphous silicon carbide or aluminium oxide.

FIG. 1B and FIG. 1C are schematic diagrams showing top and cross-sectional views showing details of transmission line 102, in this example as a co-planar waveguide (CPW) transmission line, as shown in FIG. 1A. FIG. 1B and FIG. 1C respectively show a cross-sectional and top view of a CPW 108 which is traversed by a section of conducting material 109 to form a parallel plate capacitor 110. FIG. 1B is a cross-section of FIG. 1C at the dashed line in FIG. 1C.

The parallel plate capacitor 110 may comprise a top conductive strip 109 on top of a section of dielectric material 111 and a section of the central conductive strip of the CPW 112. The top conductive layer forming the top conductive strip 109 may be realised in such a way that sections of the top conductive layer traverse the central conductive strip 112 of the CPW 108 and connect galvanically to the ground planes 113 on either side of the central conductive strip 105. Sections of the dielectric layer 111 separate the sections of the top conductive layer 109 from the central conductive strip 105, to form what may be characterised as dielectric bridges.

In other words, the CPW 108 may comprise a central conductive strip 112 flanked on either side by a section of conductive material acting as a ground 113, realised on top of a substrate 114. The central conductive strip 112 and the sections of conductive material acting as ground 113 may be formed parallel to each other. Furthermore, the parallel plate capacitor 110 may comprise a top conductive strip 109 on top of a section of dielectric material 111 and a section of the central conductive strip of the CPW 112. The dielectric material 111 may be formed broader than the top conductive strip 112 in the direction in the plane orthogonal to the top conductive strip 109. The top conductive strip 109 may be formed fully on top of the dielectric material 111 and/or may be parallel to the dielectric material 111. The top conductive strip 109 may be formed in an orthogonal direction to the central conductive strip 112 and the sections of conductive material acting as ground 113.

In between the central conductive strip 112 and the sections of conductive material acting as ground 113, the dielectric material 111 may be formed directly on the substrate 114. The dielectric material 111 may be disposed to form the parallel plate capacitor in such a way that the thickness of the dielectric material 111 in the direction orthogonal to the substrate plane is substantially the same throughout the parallel plate capacitor 110. This leads to a height profile where the dielectric material reaches higher when the dielectric material is located above the central conductive strip 112 and the sections of conductive material acting as ground 113. Since the top conductive strip 109 is formed on top of the dielectric material 111, the top conductive strip 109 can also substantially follow this height profile. However, the thickness of the top conductive strip 109 and/or the dielectric material in the direction orthogonal to the substrate plane does not have to be the same throughout the parallel plate capacitor 110. For example, the top conductive strip 110 may have a thick conductive sublayer above the central conductive strip 112 and the sections of conductive material acting as ground 113, and a thin conductive sublayer in between the central conductive strip 112 and the sections of conductive material acting as ground 113. The central conductive strip 112 and the sections of conductive material acting as ground 113 may have the same or different heights. Usually, the central conductive strip 112 and the sections of conductive material acting as ground 113 will be realised from the same conductive layer and will therefore have the same height.

In some implementations, the section of conducting material 109 traversing the central conductive strip 112 may be connected galvanically to ground 113 on either side of the central conductive strip 112 to form what may be characterised as a dielectric bridge. In certain instances, connecting ground 113 on either side of the central conductive strip 112 may prevent the formation of potential differences in the ground planes 113 on either side of the central conductive strip 112. These could otherwise allow for the propagation of spurious modes in ground 113 which can lead to losses and reflections in the JTWPA.

In some implementations, transmission line 102 may have a microstrip (MS) geometry or any other transmission line geometry. The MS geometry can comprise a bottom conductive layer which is realised on top of a substrate. On top of this conductive layer, a dielectric is realised followed by a central conductive strip.

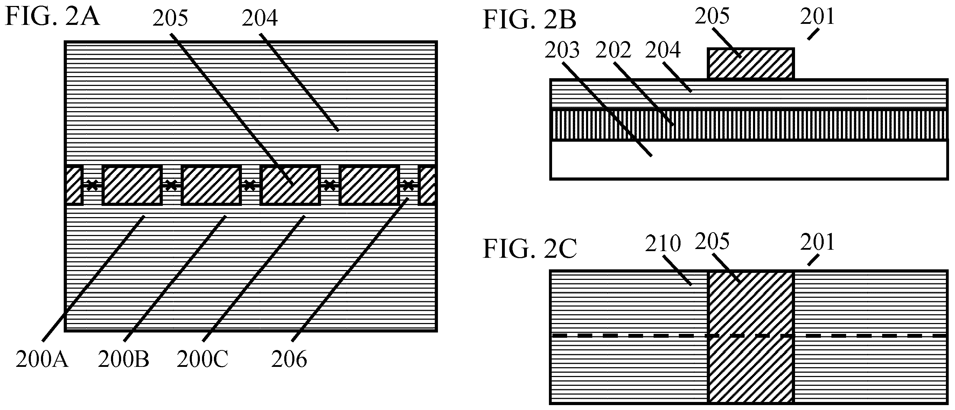

FIG. 2A, FIG. 2B and FIG. 2C respectively show a top view of a number of unit cells 200 of an example JTWPA implementing a MS geometry transmission line 201, a cross-section of said MS transmission line 201 and a detail of the top view of the MS transmission line 201. FIG. 2B is a cross-section of FIG. 2C at the dashed line in FIG. 2C. The MS transmission line 201 may comprise a conductive layer 202 which acts as a ground, and which is realised on top of a substrate 203. It may further comprise a dielectric layer 204 and a central conductive strip 205. The central conductive strip 205 is interrupted by non-linear inductors 206.

Again, in some implementations, each nonlinear inductor 206 in the exemplary JTWPA includes one or more Josephson junctions configured in parallel, in series, or in a combination thereof. In some implementations, the nonlinear inductors 206 may be realised using an array of one or more Josephson junctions comprising two superconducting plates separated by an insulating layer. In other implementations, the nonlinear inductors may be realised using an array of one or more quantum interference devices (SQUID's) or superconducting nonlinear asymmetric inductive elements (SNAIL's) or any other parallel and/or series arrangement of one or more Josephson junctions or combination thereof.

A JTWPA implementing an MS transmission line might benefit from the fact that the conductive layer acting as ground underlies the full extent of the central conductive strip. This provides a capacitance to ground per unit area of the central conductive strip which may be used to achieve a certain predefined characteristic impedance, preferably 50 Ohms. Compared to a JTWPA implementing a CPW transmission line, the intrinsic capacitance per unit area may obviate the addition of parallel plate capacitors for this purpose, reducing the required footprint and design complexity of the JTWPA.

For JTWPA's known in the art, e.g. with a CPW transmission line, the top capacitor plates and nonlinear inductors are made in separate fabrication steps.

For the MS transmission line however, where there is generally no height differences resulting from the underlying layers on which the top capacitor plates and nonlinear inductors are formed, the top capacitor plates and nonlinear inductors can be formed on a substantially flat surface. Namely, in this case, the dielectric layer 204 forms a flat surface upon which the top capacitor plates 205 and nonlinear inductors 206 can be formed. Hence, for a JTWPA with an MS transmission line, the top capacitor plates 205 and nonlinear inductors 206 can be formed in a single fabrication step using angled evaporation when the top capacitor plates 206 and nonlinear inductors 205 are formed on a flat surface such as a flat dielectric layer 204. In other words, the top capacitor plates 205 and nonlinear inductors 206 can be formed in a single instance of an angled evaporation method. In some implementations, the angled evaporation method may comprise the steps of (i) positioning at a certain orientation the chip with respect to an evaporation source, (ii) evaporating a conductive material onto the chip, (iii) oxidising the evaporated material, and possibly repeating steps (i)-(iii) with one or more other orientations.

However, when dealing with a height profile in the underlying layers such as shown in the CPW embodiments above, due to the angled and double-layer deposition of conducting material, using angled evaporation in order to fabricate the top capacitor plates and nonlinear inductors in the same step proved difficult. Hence, more fabrication steps are needed, which thus lowers the yield of production.

The angled evaporation method can comprise the formation of multiple different layers or sublayers. In the present invention, the nonlinear inductors and the top capacitor plates of the parallel plate capacitor, formed in the top conductive layer, are fabricated using an angled evaporation method in the same fabrication step, in other words in a single instance of the angled evaporation method. I.e., part of the structures that form the one or more nonlinear inductor and the one or more top capacitor plates of the parallel plate capacitor are formed in the same angled evaporation method. In other words, the angled evaporation method forms part of the structures that form the one or more nonlinear inductors and the one or more top capacitor plates of the one or more parallel plate capacitors at the same time.

In some implementations, the angled evaporation method may comprise the steps of (i) positioning at a certain orientation the chip with respect to an evaporation source, (ii) evaporating a conductive material onto the chip, (iii) oxidising the evaporated material, and possibly repeating steps (i)-(iii) with one or more other orientations. Hence, according to an embodiment of the invention, each step of the angled evaporation method forms part of the structures that form the one or more nonlinear inductors and the one or more top capacitor plates of the one or more parallel plate capacitors at the same time.

To overcome the aforementioned problem when a height profile in the underlying layers is present, the angled evaporation is done together with a specific orientation of the different layers described below. In certain instances, the invention described may reduce the footprint of the JTWPA by the use of parallel plate capacitors, which achieve a higher capacitance per unit area than planar capacitor designs and increase the throughput of JTWPA fabrication. In particular, the reduction in the number of fabrication steps reduces the fabrication time per JTWPA and increases the yield.

In some aspects of what is described here, such a JTWPA may be manufactured through a fabrication process comprising the steps of (i) producing, on a substrate, a bottom conductive layer, (ii) producing, on top of said substrate and bottom conductive layer, a dielectric layer, and (iii) producing, by means of an angled evaporation method, a top conductive layer, forming both the nonlinear inductor and the top capacitor plates of the parallel plate capacitor, formed on top of said substrate, bottom conductive layer and dielectric layer.

In some implementations, either or both of the bottom and top capacitor plates may form part of either or both of the bottom and top conductive layers.

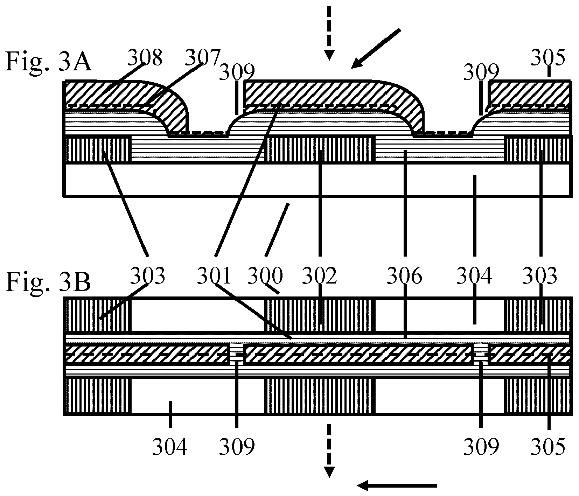

FIG. 3A-B show an example realisation of a CPW transmission line 300 and a parallel plate capacitor 301 as these might occur in a JTWPA. FIG. 3A-B do not implement some aspects of the innovations disclosed herein. FIG. 3A-B and respectively show a cross-sectional and top view of a CPW transmission line 300 and a parallel plate capacitor 301.

The CPW transmission line 300 is realised by first fabricating a bottom conductive layer comprising a central conductive strip 302 flanked by a ground 303 on either side on top of a substrate 304. The parallel plate capacitor 301 may comprise a top conductive strip 305 on top of a section of dielectric material 306 and a section of the central conductive strip of the CPW transmission line 300.

The top conductive strip 305 is fabricated using an angled evaporation method, in this example comprising first evaporating a thin conductive sublayer 307, followed by an oxidation step, followed by the evaporation of a thick conductive sublayer 308. The dashed and full arrows respectively show the projections in the plane of the drawing of the directions of angled evaporation for a thin 307 and thick 308 sublayers of conductive material. The dashed arrow can be written as the sum of two vector components, one vector component perpendicular to the substrate plane and one vector component parallel to the central conductive strip. The full arrow can also be written as the sum of two vector components, one vector component perpendicular to the substrate plane and one vector component parallel to the top conductive strip.

As mentioned before, in some implementations, the angled evaporation method may comprise the steps of (i) positioning at a certain orientation the chip with respect to an evaporation source, (ii) evaporating a conductive material onto the chip, (iii) oxidising the evaporated material, and possibly repeating steps (i)-(iii) with one or more other orientations. For the formation of Josephson Junctions, using an angled evaporation method that comprises a total of two different orientations is most common. Hence, it is preferable to use an angled evaporation method for the formation of the one or more nonlinear inductors that comprises a total of two different orientations.

In the example shown in FIG. 3A-B, shadows formed during the deposition of the thin 307 and thick 308 conductive sublayers wherever these traverse a boundary in the bottom conductive layers 302, 303 lead to open circuits 309 in the top conductive strip 305 of the parallel plate capacitor 301. In use, the arising of open circuits can have detrimental effects on the performance of a JTWPA implementing such a transmission line. More particularly, these open circuits may lead to the section of the top conductive strip 305 overlaying the central conductive strip 302 to not be substantially coupled capacitively or galvanically to the ground 303. This may result in a capacitance to ground value deviating from the intended value which can cause failed impedance matching. Other examples of negative effects include failure to connect ground 303 on either side of the central conductive strip 302, allowing for the arising of potential differences and spurious modes as discussed earlier. Or the failure to couple to other structures such as phase matching resonators, which might lead to a failed phase match and non-ideal amplification.

To overcome this problem, in some implementations of the present invention, the boundaries of sections of the bottom conductive layer, wherever these may be traversed by sections of the top conductive layer, are placed at an angle other than zero from the projections of the directions of the angled evaporation of the top conductive layer in the plane of the substrate. In other words, defining "traversed sections" as sections of the bottom conductive layer which are traversed by sections of the top conductive layer, defining the vector components of the directions of angled evaporation that are parallel to the substrate as "substrate vector components," and defining the normal vector of the boundary of the traversed sections in the plane of the substrate as the "normal vector," the traversed sections are formed in such a way that at least one of the substrate vector components is at an acute angle (< 90°), preferably 45°, to the normal vector. This can prevent the formation of open circuits due to the shadows that arise in the top conductive layer when it traverses a boundary of a section of an underlying layer. It should be noted that this is identical to altering directions of angled evaporation and similarly accounting for the consequences thereof. It should also be noted that the substrate vector components are not necessarily orthogonal, but this is preferred to simplify the Josephson junction design.

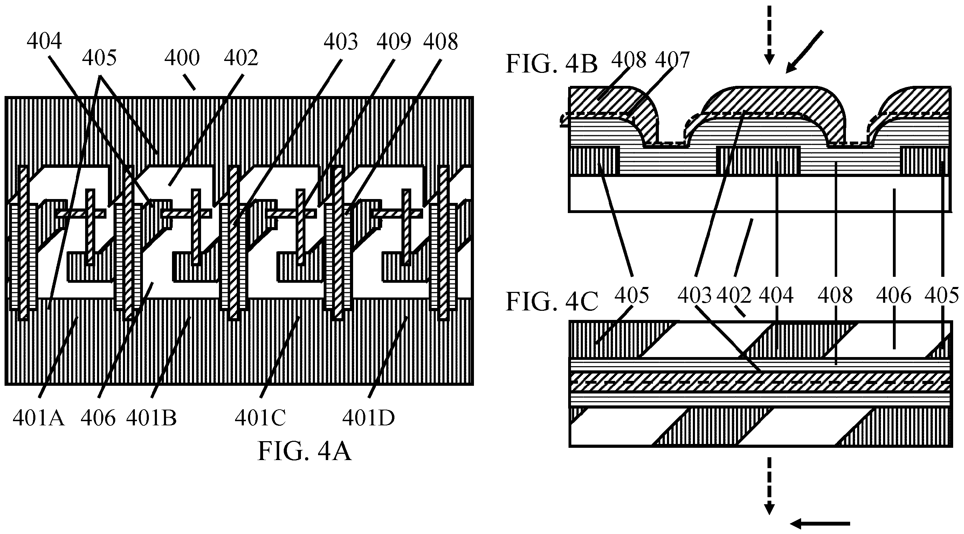

FIG. 4A, FIG. 4B and FIG. 4C implement some aspects of the innovations disclosed here, whereas FIG. 3A-B do not. FIG. 4A, FIG. 4B and FIG. 4C respectively show schematic diagram showing aspects of a number of unit cells 401 of an example JTWPA 400, a cross-sectional and top view of the CPW transmission line 402 and the parallel plate capacitor 403.

The difference between FIGS. 1A and 4A is that FIG. 1A displays a JTWPA as it might occur in the prior art. The top conductive layer in FIG. 1A needs to be fabricated in a separate, fabrication step from the nonlinear inductors to prevent the formation of undesired open circuits in the top conductive layer. The JTPWA displayed in FIG. 4A implements some aspects of what is disclosed here to allow the top capacitor plates to be formed in the same fabrication step as the nonlinear inductors while preventing the formation of open circuits. This simplifies the fabrication process and increases the throughput of JTWPA production.

In the example shown in FIGS. 4A-C, boundaries of the bottom conductive layer 404, 405 wherever this is traversed by a section of the top conductive layer 403, are placed at an angle other than zero from the projections of the directions of the angled evaporation of the top conductive layer 403 in the plane of the substrate 406 (dashed and full arrows). In other words, the sections of the bottom conductive layer which are traversed by the top conductive layer are formed at such an angle that none of the substrate vector components are parallel to these sections of the bottom conductive layer.

This arrangement can prevent the formation of open circuits in the top conductive layer 403. This is because each step in the elevation of the bottom conductive or dielectric layer is always covered by at least one of the angled evaporation sublayers 407, 408 such that the top conductive layer 403 is always continuous. In some instances, the evaporation done according to these for example two directions will create a shadow at a first side of the bottom conductive 404, 405 or dielectric 408 layer using a first direction of angled evaporation, and the second direction of angled evaporation will create a shadow at the second side of the bottom conductive layer 404, 405. Thus, both sides of the bottom conductive layer 404, 405 will have material formed thereon using the first and second directions of angled evaporation. Hence, no formation of open circuits occurs in a top conductive layer 403 are formed using this method.

Since nonlinear inductors 409 are fabricated using an angled evaporation method, the aspects of the present invention implemented in the example shown in FIGS. 4A-C allow for the fabrication of the top conductive layer 403 in the same fabrication step as the nonlinear inductors 409, leading to a shorter and simpler JTWPA fabrication process.

In general, this can result e.g. in a JTWPA comprising a substrate, a bottom conductive layer, a dielectric layer and a top conductive layer. The bottom conductive layer can be provided on top of the substrate. Here a section of the bottom conductive layer which will be traversed by a section of the top conductive layer can have a boundary that is formed along a first direction parallel to the substrate. The bottom conductive layer can e.g. form a part of a transmission line of the JTWPA which is interrupted by one or more nonlinear inductors. The dielectric layer can be provided on top of the bottom conductive layer and the substrate. A section of the dielectric layer which will be traversed by the section of the top conductive layer can have a boundary that is formed along a second direction parallel to the substrate. The top conductive layer can be provided on top of the dielectric material, the bottom conductive layer and the substrate. The section of the top conductive layer is formed along the second direction. The bottom conductive layer, the dielectric layer and the top conductive layer together form part of one or more parallel plate capacitors. The JTWPA is characterized in that the first direction and second direction are non-parallel and non-perpendicular.

The top conductive layer can thus traverse the bottom conductive layer, and the top conductive layer can be connected galvanically to side conductive layers provided on the substrate and formed at a distance on either side of the bottom conductive layer such as to form a dielectric bridge, preferably wherein the side conductive material comprises superconducting material.

The bottom conductive layer and/or the top conductive layer can comprise superconducting material. The transmission line can have a co-planar waveguide geometry.

The one or more nonlinear inductors can comprise arrays of one or more Josephson junctions configured in series, in parallel or in a combination thereof; and/or the one or more nonlinear inductors can comprise arrays of one or more superconducting quantum interference devices; and/or the one or more nonlinear inductors can comprise arrays of one or more superconducting nonlinear asymmetric inductive elements.

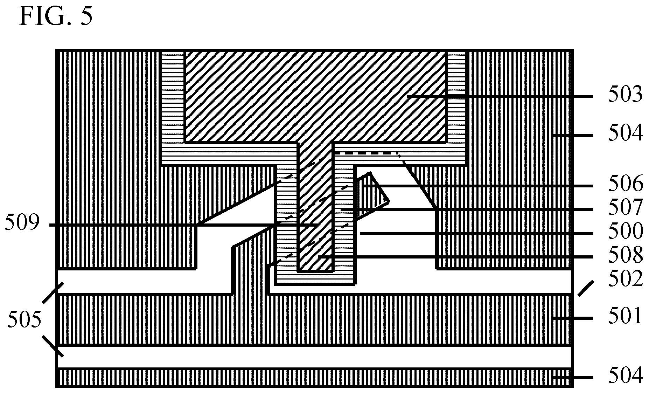

FIG. 5 is a schematic diagram showing aspects of an example parallel plate capacitor 500. In this example, the parallel plate capacitor 500 is used to couple the central conductive strip 501 of e.g., a CPW transmission line 502 to a larger parallel plate capacitor 503. In a JTWPA as presently disclosed, the larger parallel plate capacitor 503 may be connected to an inductor to form a resonant structure that may be used for phase matching.

Apart from the central conductive strip 501, the CPW transmission line 502 may further comprise a ground 504 which is separated from the central conductive strip 501 by regions of exposed substrate 505.

The parallel plate capacitor 500 may comprise a bottom plate, which itself may comprise a section of a bottom conductive layer 506, a section of a dielectric layer 507 and a top plate, which may comprise a section of a top conductive layer 508. The top and bottom plates are overlapped in such a way that the area of overlap 509 does not change in magnitude when either of the top or bottom conductive layer is shifted in the plane of the substrate with respect to the other, within reasonable fabrication uncertainties. For clarity, the boundaries of the bottom conductive layer are drawn in dashed lines there where it is obscured by an overlying layer.

In the present example, this is realised by fabricating each plate as a strip of constant width and extending each strip beyond their shared area of overlap. The length by which each strip extends beyond the area of overlap determines the amount of shift between the layers that can occur without the value of capacitance changing in magnitude. Typically, the length that the two strips extend beyond the area of overlap allows for misalignments on the order of a few micrometres.

For example, in the exemplary embodiment, the structures of the bottom and top conductive layer that form the overlap are both rectangular structures. The rectangular structures each have two ends and are formed to be non-parallel with respect to one another. The overlap is formed by a subarea of the rectangular structure of the bottom conductive layer and a subarea of the rectangular structure of the top conductive layer. If these subareas that define the overlap are positioned far enough from either end of their respective rectangular structures, a misalignment will shift one of the subareas but the misalignment will not be severe enough to reach the end of the respective rectangular structure. Hence, the area of the overlap will remain the same.

In some implementations, the top and bottom plates of the parallel plate capacitor 500 may be overlaid in a cross-like pattern. The two plates may be straight or curved or both. Furthermore, the area of overlap 509 between the two plates may in some implementations form a rectangle, a parallelogram or any other shape.

In certain instances when used in, for example, a JTWPA as presently disclosed, the parallel plate capacitor 500 reduces the variation in capacitance values which improves the accuracy and/or preciseness of the impedance and phase matching of the JTWPA, resulting in reduced gain ripples and higher gain.

In some aspects of what is described here, a parallel plate capacitor may comprise a bottom conductive plate, a dielectric and a top conductive plate. The capacitance of the capacitor is made insensitive to misalignments between the bottom and top plates by making the area of the overlap between the two plates independent, within certain uncertainty bounds set by the fabrication process, of any misalignment between the top and bottom layers. Typically, these fabrication bounds are on the order of a few micrometres, for example, 5 micrometres. The expected misalignment is typically lower, for example, 1 micrometre. In certain instances, a JTWPA implementing these parallel plate capacitors achieves a higher gain with small gain ripples. In particular, the capacitance values may be more accurately and precisely targeted which leads to a more homogenous and ideal impedance and/or phase matching in the JTWPA.

In other words, the bottom plate and the top plate both extend on either side of the overlapping area by a predefined distance, the predefined distance being chosen in such a way that the predefined distance is larger than the largest expected misalignment during manufacturing of the bottom plate and the top plate.

In some implementations, two plates may be overlapped in a cross-like pattern. In some implementations, the area of overlap between the top and bottom plates may form a rectangle, parallelogram, or any other shape. Again, in order to perform the angled evaporation in one step, boundaries of the bottom plate wherever this is traversed by a section of the top plate, are placed at an angle other than zero from the proj ections of the directions of the angled evaporation of the top plane in the plane of the substrate. In other words, the sections of the bottom plate which are traversed by the top plate are formed at such an angle that at least one of the substrate vector components is at an acute angle (< 90°), preferably 45°, to the normal vector. In some aspects of what is described here, such a parallel plate capacitor may be manufactured through a fabrication process comprising the steps of: (i) producing, on a substrate, a bottom capacitor plate, (ii) producing, on top of said substrate and bottom capacitor plate, a dielectric layer, and (iii) producing a top capacitor plate on top of said substrate, bottom capacitor plate layer and dielectric layer.

The disclosed JTWPA design has been realised using the fabrication method as disclosed and demonstrated to reproducibly and consistently achieve a gain of greater than 18 dB over bandwidths over 2 GHz with a gain ripple of 3 dB. Seven devices were fabricated and tested, that functioned according to expectation. No instances of open circuits in the top conductive layer were registered.

Any of the embodiments disclosed above may be combined in any appropriate manner.

## Claims

1. A method of manufacturing a Josephson travelling wave parametric amplifier, JTWPA, comprising:
providing a substrate;
providing, on the substrate, a bottom conductive layer;
providing, on top of the substrate and the bottom conductive layer, a dielectric layer; and
providing, by means of an angled evaporation method, a top conductive layer on top of said substrate, bottom conductive layer and dielectric layer,
wherein the top conductive layer at least partly forms one or more nonlinear inductors,
wherein the top conductive layer at least partly forms one or more top capacitor plates of one or more parallel plate capacitors and/or wherein the top conductive layer at least partly forms a top conductive strip interrupted by one or more nonlinear inductors,
wherein the top conductive layer is formed using a single instance of the angled evaporation method.

2. The method of claim 1, wherein boundaries of the bottom conductive layer, wherever it is traversed by a section of the top conductive layer, are placed at an angle other than zero from the projections of the directions of the angled evaporation of the top conductive layer in the plane of the substrate; and/or
wherein a section of the bottom conductive layer which is traversed by a section of the top conductive layer is formed in such a way that at least one of the vector components of the directions of angled evaporation that are parallel to the substrate is at an acute angle (< 90 degrees), preferably 45 degrees, to the normal vector of the boundary of the traversed section in the plane of the substrate.

3. The method of claim 1 or 2, wherein a section of the bottom conductive layer which is traversed by a section of the top conductive layer has a boundary that is formed along a first direction parallel to the substrate;
wherein a section of the dielectric layer which is traversed by the section of the top conductive layer has a boundary that is formed along a second direction parallel to the substrate;
wherein the section of the top conductive layer is formed along the second direction; and **characterized in that**:
the first direction and second direction are non-parallel and non-perpendicular.

4. The method of any one of the preceding claims, wherein the bottom conductive layer forms a part of a transmission line of the JTWPA which is interrupted by one or more nonlinear inductors, wherein the transmission line has a co-planar waveguide geometry, and wherein the bottom conductive layer, the dielectric layer and the top conductive layer together form part of one or more parallel plate capacitors, wherein the angled evaporation method at least partly forms the one or more top capacitor plates of one or more parallel plate capacitors and the one or more nonlinear inductors using the single instance of the angled evaporation method, preferably wherein the angled evaporation method comprises multiple evaporation orientations, more preferably wherein the angled evaporation method comprises two evaporation orientations.

5. The method of claim 6, wherein the top conductive layer traverses the bottom conductive layer, and wherein the top conductive layer is connected galvanically to side conductive layers provided on the substrate and formed at a distance on either side of the bottom conductive layer such as to form a dielectric bridge, preferably wherein the side conductive material comprises superconducting material.

6. The method of claim 1, wherein the JTWPA comprises a transmission line having a microstrip geometry such that the bottom conductive layer acts as a ground and such that the top conductive layer comprises one or more nonlinear inductors and a top conductive strip, wherein the top conductive strip is interrupted by the one or more nonlinear inductors; and
wherein the angled evaporation method forms at least partly the top conductive strip and the one or more nonlinear inductors using the single instance of the angled evaporation method, preferably wherein the angled evaporation method comprises multiple evaporation orientations, more preferably wherein the angled evaporation method comprises two evaporation orientations.

7. The method of any one of the preceding claims, wherein the bottom conductive layer and/or the top conductive layer comprises superconducting material; and/or
wherein the JTWPA further comprises one or more parallel plate capacitors, comprising a bottom capacitor plate and a top capacitor plate, wherein either or both of the bottom and top capacitor plates form part of either or both of the bottom and top conductive layers.

8. A Josephson travelling wave parametric amplifier, JTWPA, comprising:
a substrate;
a bottom conductive layer provided on top of the substrate;
a dielectric layer provided on top of the substrate and the bottom conductive layer; and
a top conductive layer provided by means of an angled evaporation method on top of the substrate, bottom conductive layer and dielectric layer,
wherein the top conductive layer at least partly forms one or more nonlinear inductors,
wherein the top conductive layer at least partly forms one or more top capacitor plates of one or more parallel plate capacitors and/or wherein the top conductive layer at least partly forms a top conductive strip interrupted by one or more nonlinear inductors,
wherein the top conductive layer is formed using a single instance of the angled evaporation method.

9. The JTWPA of claim 8, wherein boundaries of the bottom conductive layer, wherever it is traversed by a section of the top conductive layer, are at an angle other than zero from the projections of the directions of the angled evaporation of the top conductive layer in the plane of the substrate; and/or
wherein a section of the bottom conductive layer which is traversed by a section of the top conductive layer is formed in such a way that at least one of the vector components of the directions of angled evaporation that are parallel to the substrate is at an acute angle (< 90 degrees), preferably 45 degrees, to the normal vector of the boundary of the traversed section in the plane of the substrate.

10. The JTWPA of claim 8 or 9, wherein a section of the bottom conductive layer which is traversed by a section of the top conductive layer has a boundary that is formed along a first direction parallel to the substrate;
wherein a section of the dielectric layer which is traversed by the section of the top conductive layer has a boundary that is formed along a second direction parallel to the substrate;
wherein the section of the top conductive layer is formed along the second direction; and **characterized in that**:
the first direction and second direction are non-parallel and non-perpendicular.

11. The JTWPA of any one of claims 8-10, wherein the bottom conductive layer forms a part of a transmission line of the JTWPA which is interrupted by one or more nonlinear inductors, wherein the transmission line has a co-planar waveguide geometry, and wherein the bottom conductive layer, the dielectric layer and the top conductive layer together form part of one or more parallel plate capacitors, wherein the angled evaporation method at least partly forms the one or more top capacitor plates of one or more parallel plate capacitors and the one or more nonlinear inductors using the single instance of the angled evaporation method, preferably wherein the angled evaporation method comprises multiple evaporation orientations, more preferably wherein the angled evaporation method comprises two evaporation orientations.

12. The JTWPA of claim 11, wherein the top conductive layer traverses the bottom conductive layer, and wherein the top conductive layer is connected galvanically to side conductive layers provided on the substrate and formed at a distance on either side of the bottom conductive layer such as to form a dielectric bridge, preferably wherein the side conductive material comprises superconducting material.

13. The JTWPA of claim 8, wherein the JTWPA comprises a transmission line having a microstrip geometry such that the bottom conductive layer acts as a ground and such that the top conductive layer comprises one or more nonlinear inductors and a top conductive strip, wherein the top conductive strip is interrupted by the one or more nonlinear inductors; and
wherein the angled evaporation method forms at least partly the top conductive strip and the one or more nonlinear inductors using the single instance of the angled evaporation method, preferably wherein the angled evaporation method comprises multiple evaporation orientations, more preferably wherein the angled evaporation method comprises two evaporation orientations.

14. The JTWPA of any one of claims 8-13, wherein the bottom conductive layer and/or the top conductive layer comprises superconducting material; and/or
wherein the JTWPA further comprises one or more parallel plate capacitors, comprising a bottom capacitor plate and a top capacitor plate, wherein either or both of the bottom and top capacitor plates form part of either or both of the bottom and top conductive layers.

15. A parallel-plate capacitor, comprising:
a bottom plate and a top plate, both made of conductive material and separated by a dielectric material, wherein the bottom plate and the top plate are made to overlap in such a way that the overlapping area defines a capacitance value for the parallel-plate capacitor,
wherein the bottom plate and the top plate are both designed to extend on either side of the overlapping area by a predefined distance, the predefined distance being chosen in such a way that the predefined distance is larger than the largest expected misalignment during manufacturing of the bottom plate and the top plate, and such that as a result the overlapping area does not change during manufacturing when a misalignment occurs that is smaller than the largest expected misalignment;
preferably wherein the area of overlap of the two plates forms a rectangle, a parallelogram or a cross-like pattern.
